(19) Europäisches Patentamt

European Patent Office

Office européen des brevets

(11) Publication number: **0 079 238**
**B1**

(12) **EUROPEAN PATENT SPECIFICATION**

(45) Date of publication of patent specification: **06.04.88**

(51) Int. Cl.⁴: **H 01 L 23/36**

(21) Application number: **82305961.3**

(22) Date of filing: **09.11.82**

(54) Semiconductor devices provided with heat-dissipating means.

(30) Priority: **10.11.81 JP 180237/81**
**28.04.82 JP 70202/82**

(43) Date of publication of application:
**18.05.83 Bulletin 83/20**

(45) Publication of the grant of the patent:
**06.04.88 Bulletin 88/14**

(84) Designated Contracting States:
**DE FR GB**

(56) References cited:
**DE-A-1 151 324**

**IBM TECHNICAL DISCLOSURE BULLETIN, vol. 20, no. 4, September 1977, page 1472, New York, USA, G. DUMAINE et al.: "Air-cooled module heat dissipation"**

**IBM TECHNICAL DISCLOSURE BULLETIN, vol. 20, no. 3, August 1977, page 1007, New York, USA, U. HWANG: "Conduction air-cooled module"**

**IBM TECHNICAL DISCLOSURE BULLETIN, vol. 23, no. 9, February 1981, pages 4222-4223, New York, USA, S.W. NUTTER et al.: "Center-post heat sink"**

(73) Proprietor: **FUJITSU LIMITED**
**1015, Kamikodanaka Nakahara-ku**
**Kawasaki-shi Kanagawa 211 (JP)**

(72) Inventor: **Aoki, Hideji**
**1-47-102, Fujinodai Danchi Honmachida**
**Machida-shi Tokyo, 194 (JP)**
Inventor: **Sugimoto, Masahiro**
**5-27-13, Shonantakatori**
**Yokosuka-shi Kanagawa 237 (JP)**
Inventor: **Wakabayashi, Tetsushi**
**780-1, Minowa-cho Kohoku-ku**
**Yokohama-shi Kanagawa 223 (JP)**
Inventor: **Muratake, Kiyoshi**
**861-1, Kamikodanaka Nakahara-ku**
**Kawasaki-shi Kanagawa 211 (JP)**

(74) Representative: **Fane, Christopher Robin King et al**
**HASELTINE LAKE & CO. Hazlitt House 28 Southampton Buildings Chancery Lane London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to semiconductor devices provided with heat-dissipating means.

In a semiconductor package, especially a semiconductor package comprising a semiconductor element to be used for a bipolar logic or an emitter-coupled logic, a large scale integrated circuit performing a high-speed operation, or a power supply element, the power consumption may be large, and satisfactory attainment of a predetermined function cannot be expected unless generated heat is promptly radiated. Therefore, a heat-dissipation body such as a fin radiator may be attached to a semiconductor package in which a large quantity of heat is generated. The fin radiator comprises a support member supporting a plurality of fin plates. In such a semiconductor device, a flat surface of the radiator, which surface abuts on a flat face of a top surface of the package, is bonded to the flat face with an adhesive. With this method of attaching the radiator to the package, since the flat surface of the radiator and the flat face of the top surface of the package are bonded together with an adhesive, the strength of the resultant bonding may be sufficient, and the radiator may become separated from the package when the temperature is elevated or vibrations occur. Furthermore, deviation of the position of the radiator may occur at the bonding step so that the radiator is not secured at the preselected desired position, with the result that it may be difficult to obtain a desired heat-radiating effect.

It is desirable to provide a form of attachment of a radiator to a semiconductor device which can serve to reduce the above-mentioned defects of the previously proposed techniques. It is further desirable to provide such a form of attachment of a radiator to a semiconductor device, wherein the length of the contact portion between the radiator and the package is narrowed and the contact area is increased, whereby a high heat-radiating effect can be attained.

It has been proposed by Dumaine et al. in IBM Technical Disclosure Bulletin, Vol. 20, No. 4, September 1977, page 1472, to improve heat conductivity and thermal contact between a heat sink and a semiconductor module located on opposite sides of a printed-circuit card or board by means of molybdenum studs passing through the card or board and welded to the heat sink and brazed or otherwise embedded in the module.

According to the present invention, a semiconductor device having a heat-dissipation body fixed thereto with a projection extending from an external surface portion of the housing of the device and bonded thereto by soldering or the like being accommodated in a recess in the heat-dissipation body, is characterised in that the recess is widened at its mouth, that the said external surface portion of the housing of the device is adjacent to the heat-dissipation body, and that the heat-dissipation body is adhesively bonded to the said projection and to the said housing by means of a resin.

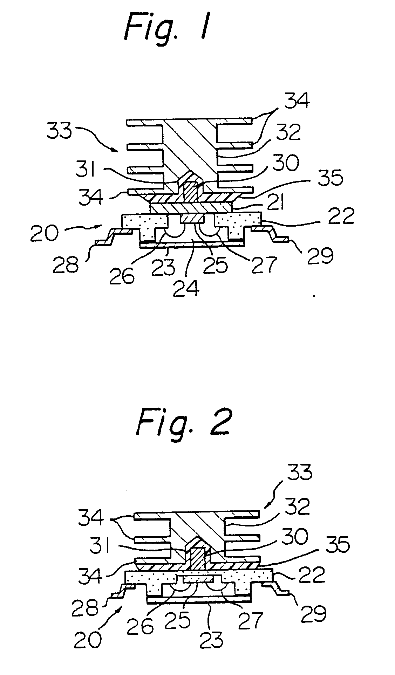

The various features of the invention are illustrated by reference to the accompanying diagrammatic drawings, in which the arrangements shown in Figs. 1 to 8 are not in accordance with the invention.

Each of Figs. 1 to 4 is an axial sectional view illustrating a semiconductor device having a heat radiator fixed thereto.

Fig. 5 shows an axial sectional view of a semiconductor device in which a radiator attachment structure is illustrated to an enlarged scale;

Fig. 6 is an exploded perspective view illustrating parts of a device;

Fig. 7 shows an axial view of the parts shown in Fig. 6 when assembled; and

Fig. 8 is an axial sectional view of another device;

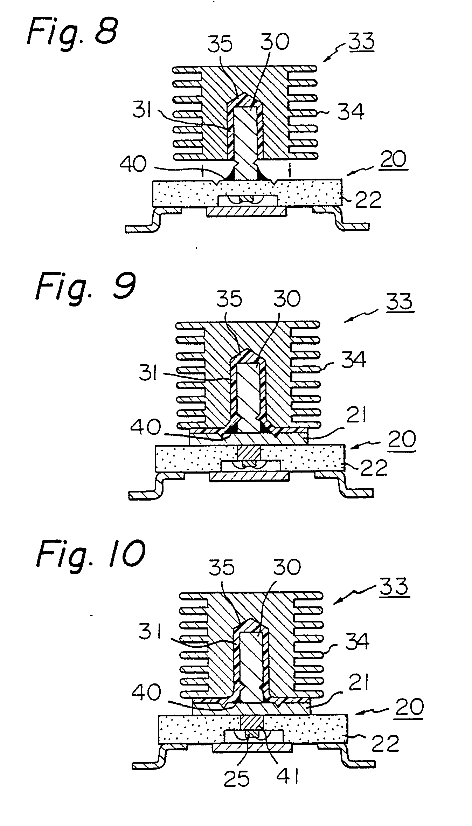

Finally, Figs. 9 and 10 show axial sectional views of two semiconductor devices embodying the present invention.

Considering Fig. 1, reference numeral 20 represents a member from which heat is radiated, for example, a semiconductor package, which comprises a plate 21 consisting of a metal such as moylbdenum, an annular ceramic material 22 such as alumina bonded to the metal plate 21 with a high-melting-point solder such as an AgCu alloy, a cap 23 bonded to the ceramic material 22 with a low-melting-point solder such as an AuSn or PbSn alloy to define a sealed interior 24, and a semiconductor element 25 attached to the interior 24. Reference numerals 26 and 27 represent inner lead lines and reference numerals 28 and 29 represent outer lead lines.

Reference numeral 30 represents a projection formed on a bonding face of the package 20, for example, the external face of the metal plate 21, by soldering or the like. This projection is, for example, a rod-like member such as a stud. The projection is made of metal such as molybdenum or copper, or ceramic such as alumina. The structure will now be described in more detail.

Reference numeral 33 represents a fin radiator comprising a supporting portion 32 having a concavity or recess 31 for receiving the stud (projection) 30. A plurality of fin plates 34 are mounted on the supporting portion 32 of the radiator 33.

A heat-conductive binder 35, for example, an epoxy resin, comprising a silicon dioxide ($SiO_2$) powder, an alumina ($Al_2O_3$) powder, or a boron nitride (BN) powder is filled into the space between the package 20, including the stud 30, and the radiator 33, whereby a strong bond is created between the package 20 and the radiator 33.

Fig. 2 illustrates a second arrangement different from that shown in Fig. 1 in that the package 20 is constructed so that a sealed space is formed between the ceramic material 22 and the cap 23, the semiconductor element 25 is contained in the sealed space to form a package free of a metal plate, and the stud 30 is formed on the ceramic material 22. Other structural members in the arrangement shown in Fig. 2 are the same as those of that shown in Fig. 1 and thus are represented by the same reference numerals as those used in Fig.

1. Therefore, an explanation of these members is omitted. Furthermore, since the effect attained in this arrangement is equivalent to that attained in that of Fig. 1, an explanation of the effect is omitted.

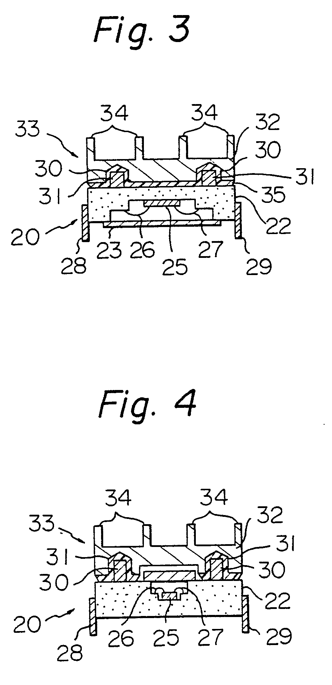

The arrangement shown in Fig. 3 is different from that shown in Fig. 2 only in that two studs 30 are formed. Since the other structural members are the same as those in the embodiment shown in Fig. 2, they are represented by the same reference numerals as in Fig. 2 and therefore an explanation of these members is omitted.

The effect attained in this arrangement is not particularly different from the effect attained in that shown in Fig. 2 except that the effect is enhanced with an increase of the number of studs.

The arrangement shown in Fig. 4 is different from that shown in Fig. 3 only in that the position of the semiconductor element 25 is changed. The other structural members in this arrangement are the same as those in Fig. 3 and thus are represented by the same reference numerals as in Fig. 3. therefore, an explanation of these structural members is omitted. Furthermore, the effect attained in this arrangement is substantially the same as the effect attained in that shown in Fig. 3.

In the foregoing arrangements, in the case where the stud 30 is formed on the ceramic material 22, a metal layer (not shown) is formed on the ceramic material 22 by printing and the stud 30 is soldered onto this metal layer.

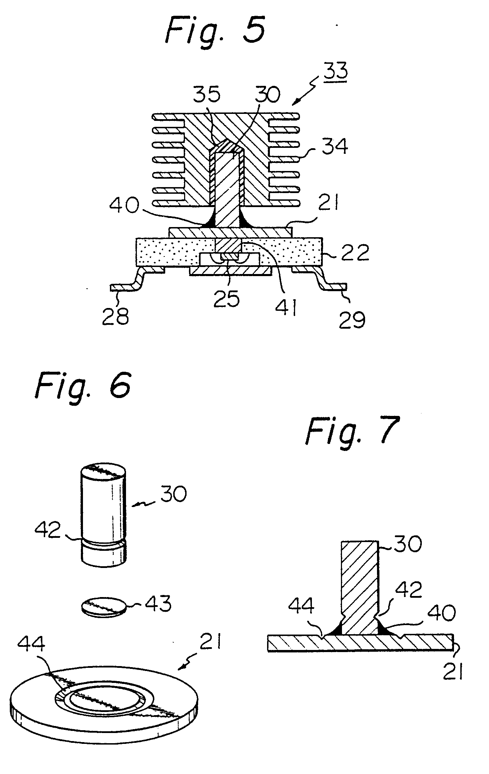

Fig. 5 is a sectional view of a semiconductor device in which a portion of the stud 30 of the radiator attachment structure is shown to a magnified scale.

In the semiconductor device shown in Fig. 5, heat generated from the semiconductor element 25 is transferred to the radiator 33 through a metal block 41, the metal plate 21, and the stud 30 and is radiated into the air through the fin plates 34.

In this semiconductor device, the stud 30 is bonded to the metal plate 21 by soldering. When a fillet 40 of the solder is large, it sometimes happens that the radiator 33 is attached to the stud 30 in the state where the lower end portion of the radiator 33 is kept in contact with this fillet 40. Since the stud 30 is bonded and secured to the radiator 33 through a resin adhesive layer 35, the radiator 33 should be electrically insulated. However, if the lower end portion of the radiator 33 is brought into contact with the fillet 40 of the solder and the radiator 33 is rendered electrically conductive, the semiconductor element 25 is electrically communicated with the radiator 33 through the metal block 41 and the metal plate 21. Therefore, if a probe is mistakenly brought into contact with the radiator 33 at the time of testing the characteristics of the semiconductor element 25, an abnormal electric current is caused to flow in the semiconductor element 25, and a problem, such as breakage of the semiconductor element, may arise.

In order to increase the heat-radiating efficiency, it is necessary that the radiator 33 be brought as close to the metal plate 21 as possible. Accordingly, it is very desirable that the radiator 33 be arranged so that it. sufficiently extends toward the base of the stud 30 without coming into contact with the fillet 40. Furthermore, it is desirable that there be no deviation of the characteristics among batches of the semiconductor device, and it is preferred that a high heat-radiating. effect be stably attained. The outer diameter of the stud 30 is about 3 mm, the inner diameter of the concavity or recess 31 is about 3.2 mm, and the clearance between the stud 30 and the wall of the recess 31 is as small as about 100 µm. In order to bring the radiator fin 33 sufficiently close to the metal plate 21 with a small clearance equally interposed throughout batches of the semiconductor device, it is desirable that the shape of the fillet 40 be uniform. A means by which the shape of the fillet 40 is predetermined and the radiator 33 is brought sufficiently close to the package 20 will now be described.

In Fig. 6, a groove 42 is formed on the periphery of the stud 30 in the vicinity of the lower end thereof, and an annular groove 44 having a diameter larger than the diameter of the stud is formed at the surface of the metal plate 21 around the region to which the stud is to be bonded. Grooves 42 and 44 may have a V-shaped or U-shaped section. A hard solder such as silver solder, is used as a solder 43.

The so-grooved stud 30 and the metal plate 21 are inserted into a heating furnace with the solder 43 being interposed therebetween and are heated and bonded together as shown in Fig. 7. At this bonding step, the fused solder is allowed to rise on the stud 30 because of the sticking force thereof and the melt flows so that it expands on the surface of the metal plate 21. However, this flow is stopped by the grooves 42 and 44 formed on the stud 30 and the metal plate 21, respectively. Therefore, the size of the fillet 40 of the solder formed between the stud 30 and the metal plate 21 is limited so that the fillet 40 has a certain shape.

Accordingly, if the grooves 42 and 44 are formed at appropriate positions, it is possible to prevent the radiator fin 33 from coming into contact with the fillet 40.

In the foregoing arrangements, the stud 30 is attached to the package 20 through a metal plate 21. If the stud attachment portion on the package 20 is metallized and the stud 30 is attached to the metallized portion as shown in Fig. 8, by forming a groove on the top face of the package 20, the flow of the solder can be controlled at the bonding step and a certain predetermined shape can be given to the fillet 40. Accordingly, in this arrangement, the radiator 33 can be brought close to the package 20, as indicated by the arrow in Fig. 8, without coming into contact with the fillet 40.

In the embodiment of the invention, the boundary of the stud-receiving recess 31 of the radiator 33 may be tapered inwards or rounded near the mouth of that recess in the vicinity of the grooves 42 and 44 for limiting the shape of the fillet, as shown in Figs. 9 and 10. This can enable the radiator 33 to be brought even closer to the package 20, so that the thermal contact between the radiator 33 and the package 20 can substantially be increased and the heat-radiating efficiency can further be enhanced.

As will readily be understood from the foregoing description, in each of the illustrated radiator attachment structures, a recess for receiving the stud soldered to the semiconductor package is formed in the radiator, and the stud is inserted into this recess and the radiator is bonded to the package through a heat-conductive adhesive. The radiator is thus tightly bonded to the package housing, and deviation of the position or separation of the radiator is thereby resisted when vibrations or shocks occur. Moreover, the efficiency of the assembling operation can be enhanced. If the stud is formed of a material having a high heat conductivity, such as molybdenum (Mo), the area of contact between the radiator and the package (including the stud) is substantially increased and the heat-radiating efficiency is improved. Moreover, by forming grooves on the stud and the package, for imparting a certain predetermined shape to the solder, it can be ensured that the radiator can be brought closer to the package, since the fillet will then not inhibit a close arrangement and cause a corresponding reduction of the heat-radiating efficiency. Finally, the arrangements according to the invention such as those shown in Figs. 9 and 10 facilitate even closer contact. A clearance can be provided between the outer surface of the stud and the boundary surfaces defining the recess in the radiator, and an adhesive can be filled into this clearance to bond the stud to the radiator. This can be advantageous over a press-bonding technique, in which a clearance is not formed.

For example, the ceramic material is less likely to be broken at the bonding step because press-bonding is not effected, and the assembling operation is thus facilitated. Furthermore, self-aligning action of the adhesive can facilitate centering of the stud in the recess.

## Claims

1. A semiconductor device (20) having a heat-dissipation body (33) fixed thereto with a projection (30) extending from an external surface portion of the housing of the device and bonded thereto by soldering or the like being accommodated in a recess (31) in the heat-dissipation body (33), characterised in that the recess (31) is widened at its mouth, that the said external surface portion of the housing of the device is adjacent to the heat-dissipation body (33), and that the heat-dissipation body (33) is adhesively bonded to the said projection (30) and to the said housing by means of a resin.

2. A device as claimed in claim 1, wherein the projection (30) is a rod-like member.

3. A device as claimed in claim 1 or 2, wherein said heat-dissipation body comprises a support portion (32) bearing a plurality of fins (34).

4. A device as claimed in any preceding claim, wherein the mouth of said recess tapers inwardly.

5. A device as claimed in any one of claims 1 to 3, wherein the said recess is bounded at its mouth by a rounded edge of the heat-dissipation body.

6. A device as claimed in any preceding claim, wherein the projection is bonded to the said external surface portion by soldering, the projection having been formed with a groove, for limiting a fillet (40) of the solder, extending around an end portion of the projection that is adjacent to the said housing.

7. A device as claimed in claim 6, wherein the said external surface portion is formed with a groove surrounding the said projection for limiting the fillet of solder.

8. A device as claimed in any preceding claim wherein a clearance exists around the said projection within the said recess, which clearance is filled with resin.

## Patentansprüche

1. Halbleitervorrichtung (20) mit einem Wärmeübergangskörper (33), der daran mit einem Vorsprung (30) befestigt ist, der sich von einem äußeren Oberflächenabschnitt des Gehäuses der Vorrichtung erstreckt, daran durch Löten oder dergleichen befestigt ist und in einer Ausnehmung (31) in dem Wärmeübergangskörper (33) aufgenommen ist, dadurch gekennzeichnet, daß die Ausnehmung (31) an ihrem Mund erweitert ist, daß der genannte äußere Oberflächenabschnitt des Gehäuses der Vorrichtung dem Wärmeübergangskörper (33) benachbart ist und daß der Wärmeübergangskörper (33) an dem genannten Vorsprung (30) und dem genannten Gehäuse mittels eines Harzes haftend befestigt ist.

2. Vorrichtung nach Anspruch 1, bei dem der Vorsprung (30) ein stabförmiges Teil ist.

3. Vorrichtung nach Anspruch 1 oder 2, bei dem der genannte Wärmeübergangskörper einen Tragabschnitt (32) umfaßt, der eine Vielzahl von Rippen (34) trägt.

4. Vorrichtung nach einem der vorhergehenden Ansprüche, bei denen der Mund der genannten nach außen hin abgeschrägt ist.

5. Vorrichtung nach einem der Ansprüche 1 bis 3, bei der die genannte Ausnehmung an ihrem Mund mit einem abgerundeten Rand des Wärmeübergangskörpers begrenzt ist.

6. Vorrichtung nach einem der vorhergehenden Ansprüche, bei der der genannte Vorsprung an dem genannten äußeren Oberflächenabschnitt durch Löten befestigt ist, wobei der Vorsprung mit einer Nut ausgebildet ist, um eine Kehlnaht (40) des Lotmittels aufzunehmen, welche sich um den Endabschnitt des Vorsprungs erstreckt, der dem Gehäuse benachbart ist.

7. Vorrichtung nach Anspruch 6, bei der der genannte Oberflächenabschnitt mit einer Nut ausgebildet ist, die den genannten Vorsprung umgibt, um die Kehlnaht des Lotmittels zu begrenzen.

8. Vorrichtung nach einem der vorhergehenden Ansprüche, bei der ein Zwischenraum um den genannten Vorsprung innerhalb der Ausnehmung besteht, welcher Zwischenraum mit Harz gefüllt ist.

**Revendications**

1. Dispositif semiconducteur (20) comprenant un corps de dissipation thermique (33) qui lui est fixé par une partie en saillie (30) s'étendant à partir d'une partie de surface externe du boîtier du dispositif et qui lui est lié par soudure ou analogue, cette partie en saillie étant disposée dans un évidement (31) dans le corps de dissipation thermique (33), caractérisé en ce que l'évidement (31) est élargi à son embouchure, en ce que la partie de surface externe du boîtier du dispositif est adjacente au corps de dissipation thermique (33), et en ce que le corps de dissipation thermique (33) est lié de façon à y adhérer à la partie en saillie (30) et au boîtier au moyen d'une résine.

2. Dispositif selon la revendication 1, dans lequel la partie en saillie (30) est un élément en forme de tige.

3. Dispositif selon l'une des revendications 1 ou 2, dans lequel le corps de dissipation thermique comprend une partie de support (32) portant une pluralité d'ailettes (34).

4. Dispositif selon l'une quelconque des revendications précédentes dans lequel la bouche de l'évidement est évasée vers l'extérieur.

5. Dispositif selon l'une quelconque des revendications 1 à 3, dans lequel l'évidement est relié à sa bouche par un bord arrondi du corps de dissipation thermique.

6. Dispositif selon l'une quelconque des revendications précédentes, dans lequel la partie en saillie est liée à la partie de surface externe par soudure, la partie en saillie ayant été munie d'une rainure, pour limiter un filet (40) de la soudure, s'étendant autour d'une partie d'extrémité de la partie en saillie qui est adjacente audit boîtier.

7. Dispositif selon la revendication 6, dans lequel la partie de surface externe est munie d'une rainure entourant la partie en saillie pour limiter le fillet de soudure.

8. Dispositif selon quelconque des revendications précédentes dans lequel un jeu existe autour de la partie en saillie dans ledit évidement, ce jeu étant rempli de résine.

# Fig. 1

# Fig. 2

# Fig. 3

# Fig. 4

# Fig. 5

35  30  33
34
40  21
22
28  25  41  29

# Fig. 6

30
42
43
44  21

# Fig. 7

30
44  42  40
21

*Fig. 8*

*Fig. 9*

*Fig. 10*